# EUROPEAN PATENT APPLICATION

(11) **EP 4 507 022 A1**
(43) Date of publication of application: **12.02.2025**
(21) Application number: 24192656.7
(22) Date of filing: 02.08.2024
(51) Int. Cl.: H01M 4/131, H01M 4/36, H01M 4/525, H01M 10/052, H01M 4/02

(54) **POSITIVE ELECTRODE ACTIVE MATERIAL, POSITIVE ELECTRODE, AND RECHARGEABLE LITHIUM BATTERIES**

(30) Priority: 03.08.2023 KR 20230101769
(71) Applicant: SAMSUNG SDI CO., LTD., Giheung-gu Yongin-si, Gyeonggi-do 17084 (KR)
(72) Inventor: KIM, Young-Ki, 17084 Yongin-si (KR); KONG, Youngsun, 17084 Yongin-si (KR); CHOO, Sung Ho, 17084 Yongin-si (KR); KANG, Seok Mun, 17084 Yongin-si (KR); YOON, Jaesang, 17084 Yongin-si (KR); DOO, Sungwook, 17084 Yongin-si (KR); KANG, Gwiwoon, 17084 Yongin-si (KR); JUNK, Dowook, 17084 Yongin-si (KR); KANG, Byungwuk, 17084 Yongin-si (KR); JEONG, Jaeyong, 17084 Yongin-si (KR)
(74) Representative: Marks & Clerk LLP

(57) **Abstract**

Disclosed are positive electrode active materials, positive electrodes, and a rechargeable lithium battery including the same. Some of the positive electrode active materials include particles of a first positive electrode active material including lithium cobalt-based oxide, and particles of a second positive electrode active material including a layered lithium nickel-manganese-based composite oxide having a nickel content of greater than or equal to about 60 mol% based on 100 mol% of a total metal excluding lithium, wherein the first positive electrode active material or the second positive electrode active material includes a coating layer including yttrium.

## Description

### BACKGROUND OF THE INVENTION

### (a) Field of the Invention

Positive electrode active materials, positive electrodes, and rechargeable lithium batteries including the same are disclosed.

### (b) Description of the Related Art

Portable information devices such as a cell phone, a laptop, a smart phone, and the like use rechargeable lithium batteries having high energy densities and easy portability. Additionally, research has been actively conducted to use rechargeable lithium batteries having high energy densities as a driving power source or power storage for hybrid or electric vehicles.

Various positive electrode active materials have been investigated to realize rechargeable lithium batteries for such applications. Among them, lithium nickel-based oxides, lithium nickel manganese cobalt composite oxides, lithium nickel cobalt aluminium composite oxides, and lithium cobalt-based oxides may be used as positive electrode active materials.

Lithium cobalt-based oxides may achieve high density in a positive electrode and exhibit high-voltage characteristics but may have problems associated with insufficient cobalt reserves and high prices. Accordingly, there have been attempts to replace the lithium cobalt-based oxides with lithium nickel-based oxides, lithium manganese-based oxides, or the like, which use elements other than cobalt or use a mixture thereof. However, some such positive electrode active materials have problems associated with realizing low average voltages and may exhibit inferior high-voltage characteristics.

### SUMMARY OF THE INVENTION

Some embodiments provide a positive electrode active material that reduces the cost associated with the positive electrode active material including lithium cobalt-based oxide, but can operate at high voltage and realize high capacity, high density, and long cycle-life.

In some embodiments, a positive electrode active material includes particles of a first positive electrode active material including lithium cobalt-based oxide, and particles of a second positive electrode active material in a form of single particles including a layered lithium nickel-manganese-based composite oxide having a nickel content of greater than or equal to about 60 mol% based on 100 mol% of a total metal content excluding lithium, wherein at least one of the first positive electrode active material and the second positive electrode active material includes a coating layer including yttrium.

In some embodiments, a positive electrode includes a positive electrode current collector and a positive electrode active material layer on the positive electrode current collector, wherein the positive electrode active material layer includes the aforementioned positive electrode active material.

In some embodiments, a rechargeable lithium battery includes the positive electrode, a negative electrode, and an electrolyte.

At least some of the above and other features of the invention are set out in the claims.

The positive electrode active material according to some embodiments can reduce the price increase due to the application of lithium cobalt-based oxide, improve high-voltage characteristics, and implement high capacity, high density, and long cycle-life characteristics.

### BRIEF DESCRIPTION OF THE DRAWINGS

FIGS. 1 to 4 are cross-sectional views schematically showing rechargeable lithium batteries according to some embodiments.
FIG. 5 is a scanning electron microscopy (SEM) image of the first positive electrode active material of Preparation Example 1.
FIG. 6 is an SEM image of the second positive electrode active material of Preparation Example 5.
FIG. 7 is an SEM image of the LCO small particles of Preparation Example 7.

### DETAILED DESCRIPTION OF THE EMBODIMENTS

Hereinafter, specific embodiments will be described in detail so that those of ordinary skill in the art can easily implement them. However, this disclosure may be embodied in many different forms and is not construed as limited to the example embodiments set forth herein.

The terminology used herein is used to describe embodiments only, and is not intended to limit the present invention. Singular expressions, such as "a," "an," and "the," include the plural expression unless the context clearly dictates otherwise.

As used herein, a "combination thereof" may be a mixture, laminate, composite, copolymer, alloy, blend, reaction product, and the like of the constituents.

Herein, it should be understood that terms such as "comprises," "includes," or "have" are intended to designate the presence of an embodied feature, number, step, element, or a combination thereof, but it does not preclude the possibility of the presence or addition of one or more other features, numbers, steps, elements, or a combination thereof.

In the drawings, the thickness of layers, films, panels, regions, etc., are exaggerated for clarity and like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

In addition, a "layer" herein includes not only a shape formed on the whole surface when viewed from a plan view, but also a shape formed on a partial surface.

In addition, the average particle diameter may be measured by a method well known to those skilled in the art, for example, may be measured by a particle size analyzer, or may be measured by a transmission electron microscopic image or a scanning electron microscopic image. Alternatively, it is possible to obtain an average particle diameter value by using a dynamic light scattering method, performing data analysis, counting the number of particles for each particle size range, and calculating from this. Unless otherwise defined, the average particle diameter may mean the diameter (D₅₀) of particles having a cumulative volume of 50 volume% in the particle size distribution. As used herein, when a definition is not otherwise provided, the average particle diameter means a diameter (D₅₀) of particles having a cumulative volume of 50 volume% in the particle size distribution that is obtained by measuring the size (diameter or length of the major axis) of about 20 particles at random in a scanning electron microscope image.

Herein, "or" is not to be construed as an exclusive meaning, for example, "A or B" is construed to include A, B, A+B, and the like.

The term "metal" includes ordinary metals, transition metals and metalloids (semi-metals).

As used herein, a composition is "based" on a set of recited constituents if the composition comprises each of the recited constituents. For example, a "lithium cobalt-based oxide" is an oxide that comprises lithium and cobalt. Similarly, an "alcohol-based solvent" is a solvent that comprises an alcohol.

As used herein, a "single particle form" is a form of particulate matter wherein the at least 90% of the particles are single crystalline without a grain boundary. In some embodiments, the particles of the single particle form may be agglomerated with, for example, fewer than 10 single particles attached to each other. In some embodiments, the particles of the single particle form are not agglomerated. The "single particle form" includes particles that may be characterized as one particle, a monolith structure, a one body structure, a single grain, or non-agglomerated particles in which the particles are not agglomerated with each other but exist as an independent phase in terms of morphology, for example, as a single crystal.

### Positive Electrode Active Material

In some embodiments, a positive electrode active material includes particles of a first positive electrode active material including lithium cobalt-based oxide, and particles of a second positive electrode active material including a layered lithium nickel-manganese-based composite oxide having a nickel content of greater than or equal to about 60 mol% based on 100 mol% of a total metal content excluding lithium, wherein at least one of the first positive electrode active material and the second positive electrode active material includes a coating layer including yttrium. In some embodiments, the second positive electrode active material is in a single particle form. The coating layer is disposed on the surface of a particle of the first positive electrode active material or disposed on the surface of a particle (e.g. single particle) of the second positive electrode active material. The yttrium coating layer may exist on only the first positive electrode active material, only the second positive electrode active material, or on both the first positive electrode active material and the second positive electrode active material.

The lithium cobalt-based oxide has excellent high-voltage characteristics due to its material characteristics and excellent density characteristics due to its particulate form and thus is widely used in some batteries. However, as the cost of cobalt, a rare meatal, sharply soars, which may increase the manufacturing cost of the lithium cobalt-based oxide positive electrode material, countermeasures are needed. There has been an attempt to use a high nickel-based positive electrode active material prepared by reducing a cobalt content, for example, lithium nickel-cobalt-manganese-based composite oxide or lithium nickel-cobalt-aluminium composite oxide, which has disadvantages such as a lower drivable average voltage than the lithium cobalt-based oxide and inferior high-voltage characteristics thereto. Cobalt-free positive electrode active materials using no cobalt have been proposed, among which a positive electrode active material having an olivine crystal structure such as lithium iron phosphate (LFP), lithium manganese phosphate (LMP), lithium manganese iron phosphate (LMFP), and the like or a spinel crystal structure such as lithium manganese oxide (LMO) and the like may have some limitation in realizing high capacity due to a small available lithium amount within the structure. A lithium nickel-manganese-based positive electrode active material having a layered structure may have excellent capacity and efficiency characteristics due to a large available lithium amount within the structure and may be suitable for a high-capacity battery, but as cobalt, which plays a key role in the layered structure, is removed therefrom, there is a problem of deteriorated structural stability or inferior high-voltage characteristics.

In some embodiments, a yttrium coating layer is applied to a first positive electrode active material and/or a second positive electrode active material. For example, the yttrium coating layer may be applied while mixing the first positive electrode active material containing lithium cobalt-based oxide and the second positive electrode active material containing lithium nickel-manganese-based composite oxide to provide a positive electrode active material having improved high-voltage characteristics, for example, initial discharge capacity and cycle-life characteristics at a high voltage as well as reduce the cobalt cost.

The second positive electrode active material, according to some embodiments, is a particulate material (e.g. in the form of single particles) including a layered compound containing nickel and manganese and thereby, may have a similar shape to that of lithium cobalt-based oxide. When mixed with the first positive electrode active material, the second positive electrode active material may realize a very high positive electrode density and excellent high-voltage characteristics. The positive electrode active material according to some embodiments may not only achieve high price competitiveness by including cobalt in a smaller content than a case of mixing large particles and small particles made of lithium cobalt-based oxide but may also realize a positive electrode density at a similar level as lithium cobalt-based oxide, which may resultantly improve capacity characteristics and cycle-life characteristics at a high voltage. In addition, in some embodiments, the yttrium coating layer may be introduced into the first positive electrode active material and/or the second positive electrode active material to increase structural stability and suppress side reactions with an electrolyte solution thus improving high-voltage characteristics.

An average particle diameter (D₅₀) of the particles of the first positive electrode active material may be larger than an average particle diameter (D₅₀) of the particles of the second positive electrode active material. In this case, the first positive electrode active material can be expressed as large particles or LCO large particles, and the second positive electrode active material can be expressed as small particles, NM small particles, or NM single-particle small particles. LCO means lithium cobalt-based oxide and NM means lithium nickel-manganese-based composite oxide. Because the first positive electrode active material includes lithium cobalt-based oxide and generally has a single particle form, the particles of the first positive electrode active material may be expressed as single particles.

The average particle diameter (D₅₀) means a diameter of particles having a cumulative volume of 50 volume% in the particle size distribution that is obtained by measuring the size (diameter or length of the major axis) of about 20 particles at random in a scanning electron microscope image.

The average particle diameter (D₅₀) of the particles of the first positive electrode active material may be, for example, about 10 µm to about 20 µm, about 10 µm to about 18 µm, or about 12 µm to about 16 µm. The average particle diameter (D₅₀) of the single particles of the second positive electrode active material may be, for example, about 0.5 µm to about 8 µm, about 1 µm to about 7 µm, about 1.5 µm to about 6 µm, or about 2 µm to about 5 µm. When the average particle diameter of each positive electrode active material satisfies the above range, high capacity and high energy density may be achieved.

The first positive electrode active material may be included in the positive electrode active material in an amount of about 60 weight% to about 95 weight%, for example, about 70 weight% to about 90 weight%, based on a total 100 weight% of the first positive electrode active material and the second positive electrode active material. The second positive electrode active material may be included in the positive electrode active material in an amount of about 5 weight% to about 40 weight%, for example, about 10 weight% to about 30 weight%, based on a total 100 weight% of the first positive electrode active material and the second positive electrode active material. When the mixing ratio of the first and second positive electrode active materials satisfies the above ranges, the energy density may be increased while maximizing capacity.

### First Positive Electrode Active Material

For example, the lithium cobalt-based oxide of the first positive electrode active material may be represented by Chemical Formula 1. [

Chemical Formula 1] Liₐ₁COx1 M¹₁₋ₓ₁O2

In Chemical Formula 1, 0.9≤a1≤1.8, 0.6≤x1≤1, and M¹ is one or more elements selected from Al, B, Ba, Ca, Ce, Cr, Cu, F, Fe, Mg, Mn, Mo, Nb, P, S, Si, Sr, Ti, V, W, and Zr.

In Chemical Formula 1, for example, 0.9≤a1≤1.5, 0.9≤a1≤1.2, or 0.95≤a1≤1.1. In addition, x1 may be 0.7≤x1≤1, 0.8≤x1≤1, 0.9≤x1≤1, or 0.95≤x1<1.

As an example, the lithium cobalt-based oxide of the first positive electrode active material may further include aluminium. Aluminium may be a dopant, and in Chemical Formula 1, M¹ may include Al. When aluminium is doped into lithium cobalt-based oxide, capacity characteristics and cycle-life characteristics at high voltage may be improved.

An aluminium content in the lithium cobalt-based oxide may be about 1 mol% to about 3 mol%, for example, about 1.5 mol% to about 2.5 mol%, based on 100 mol% of metals excluding lithium in the lithium cobalt-based oxide. When the content of the aluminium dopant satisfies the above range, the high-voltage characteristics of the first positive electrode active material can be further improved.

The first positive electrode active material may include particles including lithium cobalt-based oxide, and a coating layer disposed on the surface of the particles and including yttrium, aluminium, or a combination thereof. When the coating layer is formed on the first positive electrode active material, cycle-life characteristics or capacity characteristics at high voltage can be further improved.

When yttrium is included in the coating layer, the yttrium content of the coating layer may be about 0.01 mol% to about 1 mol%, for example, about 0.01 mol% to about 0.9 mol%, about 0.01 mol% to about 0.7 mol%, about 0.01 mol% to about 0.5 mol%, about 0.01 mol% to about 0.3 mol%, or about 0.05 mol% to about 0.1 mol% based on 100 mol% of a total metal excluding lithium in the first positive electrode active material. The yttrium content in the coating layer can be measured, for example, by SEM-EDS analysis of the surface or cross-section of the positive electrode active material. When the amount of yttrium coating on the first positive electrode active material satisfies the above range, high-voltage characteristics can be improved while minimizing capacity deterioration.

When aluminium is included in the coating layer, the aluminium content in the coating layer may be about 0.1 mol% to about 2 mol%, for example, about 0.1 mol% to about 1.5 mol%, about 0.1 mol% to about 1 mol%, about 0.1 mol% to about 0.8 mol%, or about 0.2 mol% to about 0.5 mol% based on 100 mol% of a total metal in the first positive electrode active material excluding lithium. When the amount of aluminium coating on the first positive electrode active material satisfies the above range, high-voltage characteristics can be improved while minimizing capacity deterioration.

A thickness of the coating layer of the first positive electrode active material may be about 5 nm to about 500 nm, for example, about 30 nm to about 500 nm, about 30 nm to about 450 nm, about 30 nm to about 400 nm, about 30 nm to about 350 nm, about 30 nm to about 300 nm, about 30 nm to about 250 nm, about 30 nm to about 200 nm, about 30 nm to about 150 nm, about 50 nm to about 500 nm, about 80 nm to about 500 nm, or about 100 nm to about 500 nm. When the coating layer satisfies the thickness ranges, the structural stability of the positive electrode active material may be improved without increasing resistance or reducing capacity due to the coating, and the side reaction with the electrolyte may be effectively suppressed. The thickness of the coating layer may be measured through, for example, SEM, TEM, TOF-SIMS, XPS, or EDS analysis, for example, through TEM-EDS line profile.

For example, the coating layer may include both yttrium and aluminium. For example, in the coating layer, yttrium may exist in the form of islands and aluminium may exist in the form of a continuous film.

### Second Positive Electrode Active Material

The layered lithium nickel-manganese-based composite oxide of the second positive electrode active material has a nickel content of greater than or equal to about 60 mol%, for example, about 60 mol% to about 80 mol%, about 65 mol% to about 80 mol%, about 70 mol% to about 80 mol%, about 60 mol% to about 79 mol%, about 60 mol% to about 78 mol%, or about 60 mol% to about 75 mol%, based on 100 mol% of a total metal excluding lithium in the lithium nickel-manganese composite oxide. If the nickel content satisfies the above ranges, high capacity can be achieved and structural stability can be increased even if the cobalt content is reduced.

For example, a manganese content of the second positive electrode active material may be greater than or equal to about 15 mol%, for example, about 15 mol% to about 40 mol%, about 15 mol% to about 35 mol%, about 15 mol% to about 30 mol%, or about 20 mol% to about 30 mol% based on 100 mol% of a total metal excluding lithium in the lithium nickel-manganese composite oxide. If the manganese content satisfies the above ranges, the positive electrode active material may improve structural stability while realizing high capacity.

The layered lithium nickel-manganese-based composite oxide may be a lithium nickel-manganese-aluminium-based composite oxide that further includes aluminium in addition to nickel and manganese. The inclusion of aluminium in the composite oxide may be advantageous to maintaining a stable layered structure even if the cobalt element is excluded from the structure.
The aluminium content based on 100 mol% of a total metal content excluding lithium in the layered lithium nickel-manganese-aluminium-based composite oxide may be greater than or equal to about 0.1 mol%, greater than or equal to about 0.5 mol%, or greater than or equal to about 1 mol%, for example, about 1 mol% to about 3 mol%, about 1 mol% to about 2.5 mol%, about 1 mol% to about 2 mol%, or about 1 mol% to about 1.9 mol%. If the aluminium content satisfies the above ranges, a stable layered structure may be maintained even if cobalt is excluded, structure collapse due to charging and discharging may be suppressed, and long cycle-life characteristics of the positive electrode active material may be realized.

For example, the layered lithium nickel-manganese-based composite oxide may be represented by Chemical Formula 2.

[Chemical Formula 2] Liₐ₂Niₓ₂Mn_{y2}Al_{z2}M²_{w2}O_{2-b2}X_{b2}

In Chemical Formula 2, 0.9≤a2≤1.8, 0.6≤x2≤0.8, 0.1≤y2≤0.4, 0≤z2≤0.03, 0≤w2≤0.3, 0.9≤x2+y2+z2+w2≤1.1, and 0≤b2≤0.1, M² is one or more elements selected from B, Ba, Ca, Ce, Cr, Fe, Mg, Mo, Nb, Si, Sn, Sr, Ti, V, W, and Zr, and X is one or more elements selected from F, P, and S.

In Chemical Formula 2, for example, 0.9≤a2≤1.5, or 0.9≤a2≤1.2. Additionally, Chemical Formula 2 may include aluminium, in which case it may satisfy 0.6≤x2≤0.8, 0.1 ≤y2≤0.39, 0.01 ≤z2≤0.03, and 0≤w2≤0.29, for example, 0.6≤x2≤0.8, 0.1 ≤y2≤0.39, 0.01<z2≤0.03, and 0≤w2≤0.29.

In Chemical Formula 2, for example, 0.6≤x2≤0.79, 0.6≤x2≤0.78, 0.6≤x2≤0.75, 0.65≤x2≤0.8, or 0.7≤x2≤0.79; 0.1≤y2≤0.35, 0.1≤y2≤0.30, 0.1≤y2≤0.29, 0.15≤y2≤0.39, or 0.2≤y2≤0.3; 0.01≤z2≤0.025, 0.01<z2≤0.02, or 0.01<z2≤0.019; and 0≤w2≤0.28, 0≤w2≤0.27, 0≤w2≤0.26, 0≤w2≤0.25, 0≤w2≤0.24, 0≤w2≤0.23, 0≤w2≤0.22, 0≤w2≤0.21, 0≤w2≤0.2, 0≤w2≤0.15, 0≤w2≤0.1, or 0≤w2≤0.09.

The layered lithium nickel-manganese-based composite oxide may be a cobalt-free compound that does not include cobalt or includes a very small amount of cobalt. For example, in the layered lithium nickel-manganese-based composite oxide, the cobalt content may be about 0 mol% to about 0.01 mol%, or about 0 mol% to about 0.001 mol%, based on 100 mol% of a total metal excluding lithium. By applying a second positive electrode active material that does not include cobalt or includes a very small amount of cobalt, preparing costs can be reduced, and according to some embodiments, poor high-voltage characteristics can be effectively prevented.

The second positive electrode active material may be in a single particle form. For example, the particles may each be substantially single crystalline without a grain boundary. In some embodiments, the particles of the single particle form may be agglomerated with, for example, less than 10 single particles attached to each other. In some embodiments, the particles of the single particle form are not agglomerated.

The second positive electrode active material may include a coating layer including yttrium, aluminium, or a combination thereof disposed on the surface of the single particle. As an example, the second positive electrode active material includes a coating layer including yttrium, and the coating layer may optionally further include aluminium.

The yttrium content in the coating layer of the second positive electrode active material may be about 0.01 mol% to about 1 mol%, for example, about 0.01 mol% to about 0.9 mol%, about 0.01 mol% to about 0.7 mol%, about 0.01 mol% to about 0.5 mol%, about 0.01 mol% to about 0.3 mol%, or about 0.05 mol% to about 0.1 mol% based on 100 mol% of a total metal excluding lithium in the second positive electrode active material. The yttrium content in the coating layer can be measured, for example, by SEM-EDS analysis of the surface or cross-section of the positive electrode active material. If the amount of yttrium coating on the second positive electrode active material satisfies the above range, high-voltage characteristics can be improved while minimizing capacity deterioration.

If aluminium is included in the coating layer of the second positive electrode active material, the aluminium content may be about 0.1 mol% to about 2 mol%, for example, about 0.2 mol% to about 1.9 mol%, about 0.3 mol% to about 1.8 mol%, about 0.5 mol% to about 1.5 mol%, or about 0.8 mol% to about 1.3 mol% based on 100 mol% of a total metal excluding lithium in the second positive electrode active material. This refers only to the content of aluminium included in the coating layer, separately from the aluminium included within a particle. The aluminium content in the coating layer can be measured, for example, through SEM-EDS analysis of the surface or cross-section of the positive electrode active material. If the aluminium content in the coating layer satisfies the ranges, the coating layer may have a uniform and thin thickness, which may not increase resistance of the positive electrode active material and effectively suppress a side reaction with the electrolyte and thereby, improve cycle-life characteristics of a rechargeable lithium battery under high-voltage and high-temperature conditions.

The coating layer of the second positive electrode active material may be in the form of a film that continuously surrounds the surface of a single particle, or, for example, may be in the form of a shell that surrounds the entire surface of the single particle. This is distinct from a structure in which only portion of the surface of the particle is partially coated. The coating layer according to some embodiments may be formed to have a very thin and uniform thickness as well as entirely cover the surface of the single particle, which may neither increase resistance of the positive electrode active material nor deteriorate capacity but exhibits improved structural stability and may be effectively suppressed from a side reaction with the electrolyte, resultantly realizing long cycle-life characteristics at a high voltage.

A thickness of the coating layer of the second positive electrode active material may be about 5 nm to about 500 nm, for example, about 30 nm to about 500 nm, about 30 nm to about 450 nm, about 30 nm to about 400 nm, about 30 nm to about 350 nm, about 30 nm to about 300 nm, about 30 nm to about 250 nm, about 30 nm to about 200 nm, about 30 nm to about 150 nm, about 50 nm to about 500 nm, about 80 nm to about 500 nm, or about 100 nm to about 500 nm. If the coating layer satisfies the thickness ranges, the structural stability of the positive electrode active material may be improved, for example, without increasing resistance or reducing capacity due to the coating, and side reactions with the electrolyte may be effectively suppressed. The thickness of the coating layer may be measured by, for example, SEM, TEM, TOF-SIMS, XPS, or EDS analysis, for example, by TEM-EDS line profile.

In the coating layer of the second positive electrode active material, yttrium may exist in the form of islands, and aluminium may exist in the form of a continuous film.

For example, aluminium and yttrium may be mixed within one coating layer. Alternatively, aluminium and yttrium may form separate layers. For example, the second positive electrode active material may include a first coating layer disposed on the surface of a single particle and including aluminium, and a second coating layer disposed on the first coating layer and including yttrium. A first coating layer in the form of a thin film may be formed as aluminium is first attached or absorbed to the surface of the single particle, and then yttrium may be coated on it to form a second coating layer. Of course, aluminium and yttrium may be mixed in the first coating layer and the second coating layer, but the first coating layer may be an aluminium-rich coating layer mainly composed of aluminium, and the second coating layer may be a yttrium-rich coating layer mainly composed of yttrium. In this case, the yttrium may exist in the form of islands in the second coating layer, but there is no particular limitation.

Thicknesses of the first coating layer and the second coating layer are not particularly limited. However, the thickness of the first coating layer may be about 10 nm to about 200 nm, for example, about 20 nm to about 200 nm, about 30 nm to about 200 nm, or about 30 nm to about 180 nm. The thickness of the second coating layer may be about 20 nm to about 300 nm, for example, about 20 nm to about 250 nm, about 20 nm to about 200 nm, about 30 nm to about 300 nm, or about 50 nm to about 300 nm. If each thickness satisfies the above ranges, the structural stability of the positive electrode active material can be improved without increasing resistance or decreasing capacity due to the coating, and the cycle-life characteristics at high voltage can be improved by effectively suppressing side reactions with the electrolyte.

### Method of Preparing Positive Electrode Active Material

In some embodiments, a method of preparing a positive electrode active material includes preparing a first positive electrode active material in a form of particles including lithium cobalt-based oxide; preparing a second positive electrode active material in a form of single particles including a layered lithium nickel-manganese-based composite oxide having a nickel content of greater than or equal to about 60 mol% based on 100 mol% of a total metal excluding lithium; and mixing the first positive electrode active material and the second positive electrode active material. The first positive electrode active material preparation process or the second positive electrode active material preparation process may include a coating process with yttrium. The aforementioned positive electrode active material may be prepared through the above method.

As an example, the method for preparing the positive electrode active material is a first positive electrode active material coating process, in which an yttrium raw material, an aluminium raw material, or a combination thereof is added to an aqueous solvent and mixed, and lithium cobalt-based oxide is added thereto and mixed, followed by drying and performing a first heat treatment.

The yttrium raw material may include, for example, yttrium nitrate, yttrium sulfate, yttrium carbonate, yttrium hydroxide, or a combination thereof. The aluminium raw material may include, for example, aluminium nitrate, aluminium sulfate, aluminium carbonate, aluminium hydroxide, or a combination thereof. The aqueous solvent may include distilled water, an alcohol-based solvent, or a combination thereof.

When performing yttrium coating, the yttrium content in the yttrium raw material may be designed to be about 0.01 mol% to about 1 mol%, for example about 0.01 mol% to about 0.9 mol%, about 0.01 mol% to about 0.7 mol%, about 0.01 mol% to about 0.5 mol%, about 0.01 mol% to about 0.3 mol%, or about 0.05 mol% to about 0.1 mol% based on 100 mol% of all metals excluding lithium in the first positive electrode active material. If the amount of yttrium coating on the first positive electrode active material satisfies the above range, high-voltage characteristics can be improved while minimizing capacity deterioration.

When performing aluminium coating, the aluminium content in the aluminium raw material may be designed to be about 0.1 mol% to about 2 mol%, for example, about 0.2 mol% to about 1.9 mol%, about 0.3 mol% to about 1.8 mol%, about 0.5 mol% to about 1.5 mol%, or about 0.8 mol% to about 1.3 mol% based on 100 mol% of a total metal excluding lithium in the first positive electrode active material.

The first heat treatment may be performed to form a coating layer on the surface of lithium cobalt-based oxide particles, for example, in an oxygen atmosphere in a temperature range of about 700 °C to about 950 °C, about 750 °C to about 950 °C, or about 800 °C to about 950 °C for about 2 to about 20 hours, or about 3 to about 10 hours.

As an example, the method for preparing the positive electrode active material is a second positive active material coating process, in which an yttrium raw material, an aluminium raw material, or a combination thereof is added to an aqueous solvent and mixed, and the single particle layered lithium nickel-manganese-based composite oxide is added thereto and mixed, followed by drying and performing a second heat treatment.

Since the lithium nickel-manganese-based composite oxide has a significantly different residual lithium content and different surface characteristics from an oxide with other compositions, for example, a conventional nickel-based oxide such as a lithium nickel-cobalt-manganese-based composite oxide or a lithium nickel-cobalt-aluminium-based composite oxide, etc., conventional coating methods may not succeed in forming a good coating layer thereon in the form of a uniform film. In some embodiments, a method is applied to improve high-voltage characteristics by uniformly forming a coating layer with a very thin thickness on the surface of a layered lithium nickel-manganese-based composite oxide with a very small amount of cobalt and a nickel content of greater than or equal to about 60 mol%.

The yttrium raw material may include, for example, yttrium nitrate, yttrium sulfate, yttrium carbonate, yttrium hydroxide, or a combination thereof. The aluminium raw material may include, for example, aluminium nitrate, aluminium sulfate, aluminium carbonate, aluminium hydroxide, or a combination thereof. For example, the aluminium raw material may include aluminium sulfate, and in this case, it is advantageous to form a coating layer with a uniform thickness on the surface of the lithium nickel-manganese composite oxide particles. The aqueous solvent may include distilled water, an alcohol-based solvent, or a combination thereof.

When performing yttrium coating, the yttrium content in the yttrium raw material may be about 0.01 mol% to about 1 mol%, for example, about 0.01 mol% to about 0.9 mol%, about 0.01 mol% to about 0.7 mol%, about 0.01 mol% to about 0.5 mol%, about 0.01 mol% to about 0.3 mol%, or about 0.05 mol% to about 0.1 mol% based on 100 mol% of all metals excluding lithium in the second positive electrode active material. If the amount of yttrium coating on the second positive electrode active material satisfies the above range, high-voltage characteristics can be improved while minimizing capacity deterioration.

When performing aluminium coating, the aluminium content in the aluminium raw material may be in a range of about 0.1 mol% to about 2 mol%, for example, about 0.2 mol% to about 1.9 mol%, about 0.3 mol% to about 1.8 mol%, about 0.5 mol% to about 1.5 mol%, or about 0.8 mol% to about 1.3 mol% based on 100 mol% of a total metal excluding lithium in the second positive electrode active material. If the contents of the coating raw materials are designed to have the ranges, the coating layer may be formed to have a thin and uniform thickness of tens or hundreds of nanometers, which may reduce an amount of generated gas of a rechargeable lithium battery under high voltage conditions and improve high-capacity and long cycle-life characteristics.

A solution obtained by mixing an yttrium raw material, an aluminium raw material, or a combination thereof in an aqueous solvent may have pH of about 1.5 to about 3.5, for example, about 2.0 to about 3.4, about 2.5 to about 3.3, about 2.7 to about 3.3, or about 2.9 to about 3.2. The layered lithium nickel-manganese-based composite oxide in the single particle form may be mixed with the solution for, for example, about 5 minutes to about 80 minutes, about 5 minutes to about 60 minutes, or about 5 minutes to about 40 minutes. After the stirring, the mixed solution may have a pH of about 4.5 to about 8.5, for example, about 5.0 to about 8.0, about 5.5 to about 7.5, or about 6.0 to about 7.0. In some embodiments, these conditions provide a coating layer with a uniform thickness.

The second heat treatment may be performed, for example, at about 700 °C to about 850 °C, about 750 °C to about 840 °C, or about 800 °C to about 830 °C under an oxygen atmosphere for about 2 hours to about 20 hours or about 3 hours to about 10 hours.

The first positive electrode active material and the second positive electrode active material may be mixed at a weight ratio of about 60:40 to about 95:5, for example, about 70:30 to about 90:10. In some embodiments, the capacity and cycle-life characteristics can be improved while maximizing energy density by mixing the electrode active materials in this ratio.

### Positive Electrode

In some embodiments, a positive electrode includes a positive electrode current collector and a positive electrode active material layer on the positive electrode current collector, wherein the positive electrode active material layer includes the aforementioned positive electrode active material. The positive electrode active material layer may further include other types of positive electrode active materials in addition to the positive electrode active materials described above. Additionally, the positive electrode active material layer may optionally further include a binder, a conductive material, or a combination thereof.

According to some embodiments, a loading level of the positive electrode active material layer may be about 10 mg/cm² to about 40 mg/cm², for example about 10 mg/cm² to about 30 about mg/cm², or about 10 mg/cm² to about 20 mg/cm². Additionally, a density of the positive electrode active material layer in the final compressed positive electrode may be about 3.5 g/cc to about 3.7 g/cc, for example, about 3.5 g/cc to about 3.6 g/cc, or about 3.5 g/cc to about 3.58 g/cc. When applying the positive electrode active material according to some embodiments, it may be advantageous to implement such a loading level and positive electrode density, and a positive electrode that satisfies the loading level and positive electrode density in the above range is suitable for implementing a high-capacity, high-energy-density rechargeable lithium battery. The density of the positive electrode active material layer refers to the ratio of the weight to the volume of the pressed positive active material layer. The density of the positive electrode active material layer can be measured by measuring a cross-sectional area, thickness and weight of the positive active material layer excluding the positive electrode current collector, calculating the volume by multiplying the cross-sectional area and the thickness, and dividing the weight by the volume.

### Binder

The binder improves binding properties of positive electrode active material particles with one another and with a current collector. Examples of binders may include polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinylpyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but are not limited thereto.

### Conductive Material

Conductive material may be included to provide electrode conductivity and any electrically conductive material may be used as a conductive material unless it causes a chemical change. Examples of the conductive material may include a carbon-based material such as natural graphite, artificial graphite, carbon black, acetylene black, ketjen black, a carbon fiber, a carbon nanofiber, a carbon nanotube, and the like; a metal-based material of a metal powder or a metal fiber including copper, nickel, aluminium, silver, and the like; a conductive polymer such as a polyphenylene derivative; or a mixture thereof.

The binder and the conductive material may each independently be about 0.5 weight% to about 5 weight% or about 0.5 weight% to about 3 weight%, based on 100 weight% of the positive electrode active material layer.

The positive electrode current collector may include Al, but is not limited thereto.

### Rechargeable Lithium Battery

Some embodiments provide a rechargeable lithium battery including the aforementioned positive electrode, negative electrode, and electrolyte.

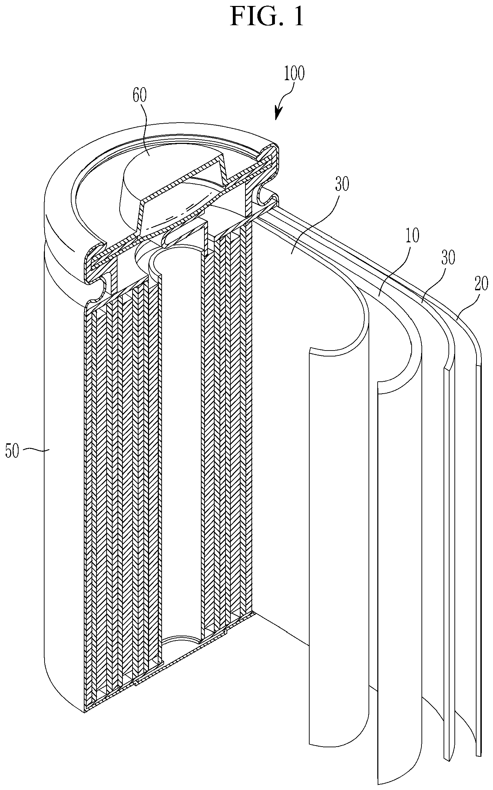

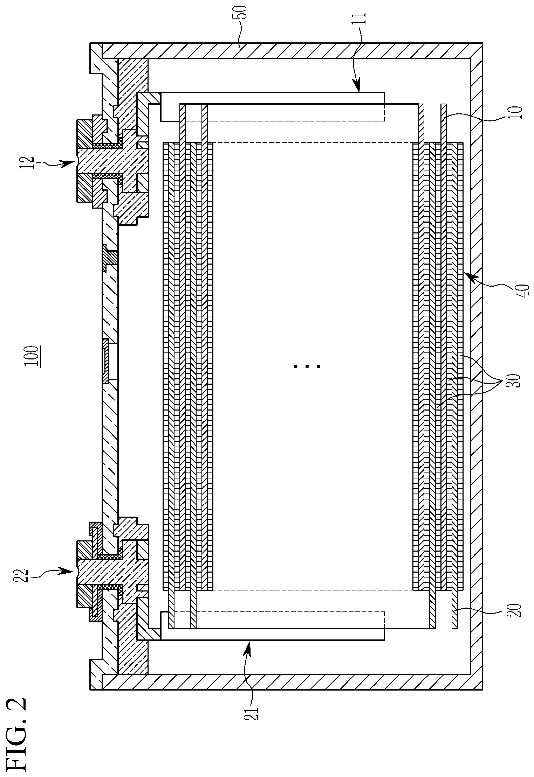

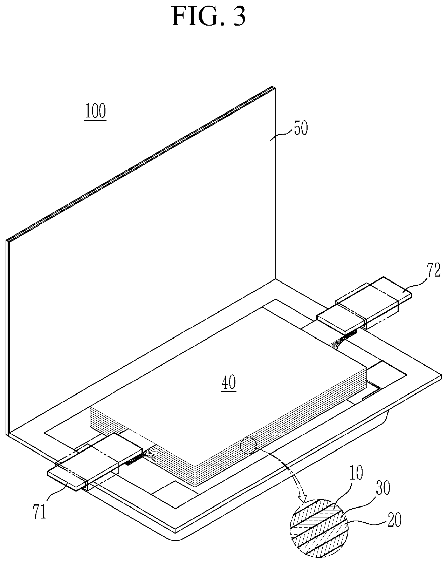

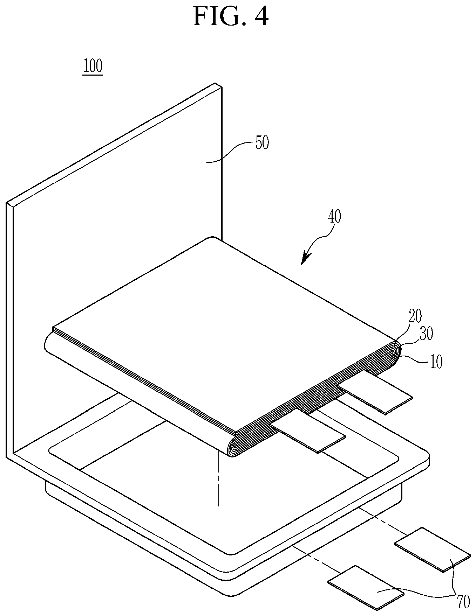

The rechargeable lithium battery may be cylindrical, prismatic, pouch, coin, etc. depending on the shape. FIGS. 1 to 4 are schematic views illustrating a rechargeable lithium battery according to an embodiment. FIG. 1 shows a cylindrical battery, FIG. 2 shows a prismatic battery, and FIGS. 3 and 4 show pouch-type batteries. Referring to FIGS. 1 to 4, the rechargeable lithium battery 100 includes an electrode assembly 40 with a separator 30 interposed between the positive electrode 10 and the negative electrode 20, and a case 50 in which the electrode assembly 40 is housed. The positive electrode 10, negative electrode 20, and separator 30 may be impregnated with an electrolyte (not shown). The rechargeable lithium battery 100 may include a sealing member 60 sealing the case 50 as shown in FIG. 1. In addition, in FIG. 2, the rechargeable lithium battery 100 may include a positive lead tab 11, a positive terminal 12, a negative lead tab 21, and a negative terminal 22. As shown in FIGS. 3 and 4, the rechargeable lithium battery 100 may include an electrode tab 70, that is, a positive electrode tab 71 and a negative electrode tab 72 serving as an electrical path for inducing the current formed in the electrode assembly 40 to the outside.

The rechargeable lithium battery according to some embodiments may be rechargeable at a high voltage, or may be suitable for being driven at a high voltage. For example, the charging voltage of the rechargeable lithium battery may be greater than or equal to about 4.45 V, about 4.45 V to about 4.7 V, about 4.45 V to about 4.6 V, or about 4.45 V to about 4.55 V. By applying the positive electrode active material according to some embodiments, the rechargeable lithium battery can significantly reduce an amount of gas generated even when charged at high voltage and can achieve high capacity and long cycle-life characteristics.

### Negative Electrode

The negative electrode may include a current collector and a negative electrode active material layer on the current collector, and may further include a negative electrode active material, a binder, a conductive material, or a combination thereof.

### Negative Electrode Active Material

The negative electrode active material may include a material that reversibly intercalates/deintercalates lithium ions, a lithium metal, a lithium metal alloy, a material capable of doping/dedoping lithium, or transition metal oxide.

The material that reversibly intercalates/deintercalates lithium ions may include, for example, crystalline carbon, amorphous carbon, or a combination thereof as a carbon-based negative electrode active material. The crystalline carbon may be irregular, or sheet, flake, spherical, or fiber shaped natural graphite or artificial graphite. The amorphous carbon may be a soft carbon, a hard carbon, a mesophase pitch carbonization product, calcined coke, and the like.

The lithium metal alloy includes an alloy of lithium and a metal selected from Na, K, Rb, Cs, Fr, Be, Mg, Ca, Sr, Si, Sb, Pb, In, Zn, Ba, Ra, Ge, Al, and Sn.

The material capable of doping/dedoping lithium may be a Si-based negative electrode active material or a Sn-based negative electrode active material. The Si-based negative electrode active material may include silicon, a silicon-carbon composite, SiOₓ (0 < x < 2), a Si-Q alloy (wherein Q is an element selected from an alkali metal, an alkaline-earth metal, a Group 13 element, a Group 14 element (excluding Si), a Group 15 element, a Group 16 element, a transition metal, a rare earth element, and a combination thereof, for example Mg, Ca, Sr, Ba, Ra, Sc, Y, Ti, Zr, Hf, Rf, V, Nb, Ta, Db, Cr, Mo, W, Sg, Tc, Re, Bh, Fe, Pb, Ru, Os, Hs, Rh, Ir, Pd, Pt, Cu, Ag, Au, Zn, Cd, B, Al, Ga, Sn, In, Tl, Ge, P, As, Sb, Bi, S, Se, Te, Po, and a combination thereof), or a combination thereof. The Sn-based negative electrode active material may be Sn, SnO₂, a Sn alloy, or a combination thereof.

The silicon-carbon composite may be a composite of silicon and amorphous carbon. An average particle diameter (D₅₀) of the silicon-carbon composite particles may be, for example, about 0.5 µm to about 20 µm. According to some embodiments, the silicon-carbon composite may be in the form of silicon particles and amorphous carbon coated on the surface of the silicon particles. For example, it may include a secondary particle (core) in which silicon primary particles are assembled and an amorphous carbon coating layer (shell) on the surface of the secondary particle. The amorphous carbon may also be present between the silicon primary particles, for example, the silicon primary particles may be coated with amorphous carbon. The secondary particles may exist dispersed in an amorphous carbon matrix.

The silicon-carbon composite may further include crystalline carbon. For example, the silicon-carbon composite may include a core including crystalline carbon and silicon particles and an amorphous carbon coating layer on the surface of the core. The crystalline carbon may be artificial graphite, natural graphite, or a combination thereof. The amorphous carbon may include soft carbon or hard carbon, a mesophase pitch carbonized product, and calcined coke.

When the silicon-carbon composite includes silicon and amorphous carbon, a content of silicon may be about 10 weight% to about 50 weight% and a content of amorphous carbon may be about 50 weight% to about 90 weight% based on 100 weight% of the silicon-carbon composite. In addition, when the composite includes silicon, amorphous carbon, and crystalline carbon, a content of silicon may be about 10 weight% to about 50 weight%, a content of crystalline carbon may be about 10 weight% to about 70 weight%, and a content of amorphous carbon may be about 20 weight% to about 40 weight% based on 100 weight% of the silicon-carbon composite.

Additionally, a thickness of the amorphous carbon coating layer may be about 5 nm to about 100 nm. An average particle diameter (D₅₀) of the silicon particles (primary particles) may be about 10 nm to about 1 µm, or about 10 nm to about 200 nm. The silicon particles may exist as silicon alone, in the form of a silicon alloy, or in an oxidized form. The oxidized form of silicon may be represented by SiOₓ (0<x<2). At this time, the atomic content ratio of Si:O, which indicates a degree of oxidation, may be about 99:1 to about 33:67. As used herein, when a definition is not otherwise provided, an average particle diameter (D₅₀) indicates a particle where an accumulated volume is about 50 volume% in a particle distribution.

The Si-based negative electrode active material or Sn-based negative electrode active material may be mixed with the carbon-based negative electrode active material. When the Si-based negative electrode active material or Sn-based negative electrode active material and the carbon-based negative electrode active material are mixed and used, the mixing ratio may be a weight ratio of about 1:99 to about 90:10.

### Binder

The binder serves to adhere the negative electrode active material particles to each other and also to adhere the negative electrode active material to the current collector. The binder may be a non-aqueous binder, an aqueous binder, a dry binder, or a combination thereof.

The non-aqueous binder may include polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, or a combination thereof.

The aqueous binder may include a styrene-butadiene rubber, a (meth)acrylated styrene-butadiene rubber, a (meth)acrylonitrile-butadiene rubber, a (meth)acrylic rubber, butyl rubber, a fluorine rubber, polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resin, polyvinyl alcohol, or a combination thereof.

When an aqueous binder is used as the negative electrode binder, a cellulose-based compound capable of imparting viscosity may be further included. As the cellulose-based compound, one or more of carboxymethyl cellulose, hydroxypropylmethyl cellulose, methyl cellulose, or alkali metal salts thereof may be mixed and used. The alkali metal may be Na, K, or Li.

The dry binder may be a polymer material capable of becoming fiber, and may be, for example, polytetrafluoroethylene, polyvinylidene fluoride, a polyvinylidene fluoride-hexafluoropropylene copolymer, polyethylene oxide, or a combination thereof.

### Conductive Material

The conductive material may be included to provide electrode conductivity and any electrically conductive material may be used as a conductive material unless it causes a chemical change. Examples of the conductive material include a carbon-based material such as natural graphite, artificial graphite, carbon black, acetylene black, ketjen black, a carbon fiber, a carbon nanofiber, a carbon nanotube, and the like; a metal-based material of a metal powder or a metal fiber including copper, nickel, aluminium, silver, and the like; a conductive polymer such as a polyphenylene derivative; or a mixture thereof.

A content of the negative electrode active material may be about 95 weight% to about 99.5 weight% based on 100 weight% of the negative electrode active material layer, and a content of the binder may be about 0.5 weight% to about 5 weight% based on 100 weight% of the negative electrode active material layer. For example, the negative electrode active material layer may include about 90 weight% to about 99 weight% of the negative electrode active material, about 0.5 weight% to about 5 weight% of the binder, and about 0.5 weight% to about 5 weight% of the conductive material.

### Current Collector

The negative electrode current collector may include, for example, indium (In), copper (Cu), magnesium (Mg), stainless steel, titanium (Ti), iron (Fe), cobalt (Co), nickel (Ni), zinc (Zn), aluminium (Al), germanium (Ge), lithium (Li), or an alloy thereof, and may be in the form of a foil, sheet, or foam. A thickness of the negative electrode current collector may be, for example, about 1 µm to about 20 µm, about 5 µm to about 15 µm, or about 7 µm to about 10 µm.

### Electrolyte

The electrolyte for a rechargeable lithium battery may include, for example, a non-aqueous organic solvent and a lithium salt.

The non-aqueous organic solvent serves as a medium for transmitting ions taking part in the electrochemical reaction of a battery. The non-aqueous organic solvent may be a carbonate-based, ester-based, ether-based, ketone-based, or alcohol-based solvent, an aprotic solvent, or a combination thereof.

The carbonate-based solvent may include dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and the like. The ester-based solvent may include methyl acetate, ethyl acetate, n-propyl acetate, dimethyl acetate, methyl propionate, ethyl propionate, decanolide, mevalonolactone, valerolactone, caprolactone, and the like. The ether-based solvent may include dibutyl ether, tetraglyme, diglyme, dimethoxyethane, 2-methyltetrahydrofuran, 2,5-dimethyltetrahydrofuran, tetrahydrofuran, and the like. In addition, the ketone-based solvent may include cyclohexanone, and the like. The alcohol-based solvent may include ethanol, isopropyl alcohol, and the like and the aprotic solvent may include nitriles such as R-CN (wherein R is a C₂ to C₂₀ linear, branched, or cyclic hydrocarbon group, a double bond, an aromatic ring, or an ether group), and the like; amides such as dimethylformamide; dioxolanes such as 1,3-dioxolane, 1,4-dioxolane, and the like; sulfolanes, and the like.

The non-aqueous organic solvent can be used alone or in a mixture of two or more types, and when two or more types are used in a mixture, a mixing ratio can be appropriately adjusted according to the desired battery performance, which is widely known to those working in the field.

When using a carbonate-based solvent, a cyclic carbonate and a chain carbonate may be mixed and used, and the cyclic carbonate and the chain carbonate may be mixed in a volume ratio of about 1:1 to about 1:9.

The non-aqueous organic solvent may further include an aromatic hydrocarbon-based organic solvent. For example, a carbonate-based solvent and an aromatic hydrocarbon-based organic solvent may be mixed and used in a volume ratio of about 1:1 to about 30:1.

The electrolyte may further include vinylethyl carbonate, vinylene carbonate, or an ethylene carbonate-based compound to improve battery cycle-life.

Examples of the ethylene carbonate-based compound may include fluoroethylene carbonate, difluoroethylene carbonate, chloroethylene carbonate, dichloroethylene carbonate, bromoethylene carbonate, dibromoethylene carbonate, nitroethylene carbonate, and cyanoethylene carbonate.

The lithium salt dissolved in the organic solvent supplies lithium ions in a battery, enables a basic operation of a rechargeable lithium battery, and improves transportation of the lithium ions between positive and negative electrodes. Examples of the lithium salt may include at least one selected from LiPF₆, LiBF₄, LiSbF₆, LiAsF₆, LiClO₄, LiAlO₂, LiAlCl₄, LiPO₂F₂, LiCl, Lil, LiN(SO₃C₂F₅)₂, Li(FSO₂)₂N (lithium bis(fluorosulfonyl)imide; LiFSI), LiC₄F₉SO₃, LiN(CₓF₂ₓ₊₁SO₂)(C_{y}F_{2y+1}SO₂), (wherein x and y are integers of 1 to 20), lithium trifluoromethane sulfonate, lithium tetrafluoroethanesulfonate, lithium difluorobis(oxalato)phosphate (LiDFOB), and lithium bis(oxalato) borate (LiBOB).

A concentration of lithium salt may be within the range of about 0.1 M to about 2.0 M. When the concentration of lithium salt is within the above range, the electrolyte has appropriate ionic conductivity and viscosity, and thus excellent performance can be achieved and lithium ions can move effectively.

### Separator

Depending on the type of the rechargeable lithium battery, a separator may be present between the positive electrode and the negative electrode. The separator may include polyethylene, polypropylene, polyvinylidene fluoride, or a multilayer film of two or more layers thereof, and a mixed multilayer film such as a polyethylene/polypropylene two-layer separator, polyethylene/polypropylene/polyethylene three-layer separator, polypropylene/polyethylene/polypropylene three-layer separator, and the like.

The separator may include a porous substrate and a coating layer including an organic material, an inorganic material, or a combination thereof on one or both surfaces of the porous substrate.

The porous substrate may be a polymer film formed of any one selected polymer polyolefin such as polyethylene and polypropylene, polyester such as polyethylene terephthalate and polybutylene terephthalate, polyacetal, polyamide, polyimide, polycarbonate, polyether ketone, polyarylether ketone, polyether ketone, polyetherimide, polyamideimide, polybenzimidazole, polyethersulfone, polyphenylene oxide, a cyclic olefin copolymer, polyphenylene sulfide, polyethylene naphthalate, a glass fiber, TEFLON, and polytetrafluoroethylene, or a copolymer or mixture of two or more thereof.

The porous substrate may have a thickness of about 1 µm to about 40 µm, for example, about 1 µm to about 30 µm, about 1 µm to about 20 µm, about 5 µm to about 15 µm, or about 10 µm to about 15 µm.

The organic material may include a (meth)acryl-based copolymer including a first structural unit derived from (meth)acrylamide, and a second structural unit including at least one of a structural unit derived from (meth)acrylic acid or (meth)acrylate, and a structural unit derived from (meth)acrylamidosulfonic acid or a salt thereof.

The inorganic material may include inorganic particles selected from Al₂O₃, SiO₂, TiO₂, SnO₂, CeO₂, MgO, NiO, CaO, GaO, ZnO, ZrO₂, Y₂O₃, SrTiOs, BaTiOs, Mg(OH)₂, boehmite, and a combination thereof, but is not limited thereto. An average particle diameter (D₅₀) of the inorganic particles may be about 1 nm to about 2000 nm, for example, about 100 nm to about 1000 nm, or about 100 nm to about 700 nm.

The organic material and the inorganic material may be mixed in one coating layer, or a coating layer including an organic material and a coating layer including an inorganic material may be stacked.

The thickness of the coating layer may be about 0.5 µm to about 20 µm, for example, about 1 µm to about 10 µm, or about 1 µm to about 5 µm.

**Some Additional non-limiting embodiments include:**
A1. An embodiment "A" of a positive electrode active material, comprising particles of a first positive electrode active material comprising a lithium cobalt-based oxide, and particles of a second positive electrode active material, optionally in a form of single particles, comprising a layered lithium nickel-manganese-based composite oxide having a nickel content of greater than or equal to about 60 mol% based on 100 mol% of a total metal content of the second positive electrode active material excluding lithium, wherein the first positive electrode active material or the second positive electrode active material is coated with a layer comprising yttrium.
A2. The positive electrode active material of embodiment A1, wherein an average particle diameter (D₅₀) of the particles of the first positive electrode active material is larger than an average particle diameter (D₅₀) of the single particles of the second positive electrode active material.
A3. The positive electrode active material of embodiment A1, wherein an average particle diameter (D₅₀) of the particles of the first positive electrode active material ranges from about 10 µm to about 20 µm, and an average particle diameter (D₅₀) of the single particles of the second positive electrode active material ranges from about 0.5 µm to about 8 µm.
A4. The positive electrode active material of embodiment A1, wherein the first positive electrode active material is about 60 weight % to about 95 weight % of the positive electrode active material, and the second positive electrode active material is about 5 weight % to about 40 weight % of the positive electrode active material.
A5. The positive electrode active material of embodiment A1,
   wherein the lithium cobalt-based oxide of the first positive electrode active material is represented by Chemical Formula 1:

   [Chemical Formula 1] Liₐ₁COₓ₁M¹₁₋ₓ₁O2

   wherein, in Chemical Formula 1, 0.9≤a1≤1.8, 0.6≤x1≤1, and M¹ is one or more elements selected from Al, B, Ba, Ca, Ce, Cr, Cu, F, Fe, Mg, Mn, Mo, Nb, P, S, Si, Sr, Ti, V, W, and Zr.
A6. The positive electrode active material of embodiment A1, wherein the lithium cobalt-based oxide of the first positive electrode active material further includes aluminium, and an aluminium content in the lithium cobalt-based oxide is about 1 mol% to about 3 mol% based on 100 mol% of metals in the lithium cobalt-based oxide excluding lithium.
A7. The positive electrode active material of embodiment A1, wherein the particles of the first positive electrode active material comprise lithium cobalt-based oxide and a coating layer disposed on the surface of the particles that comprises yttrium, aluminium, or a combination of yttrium and aluminium.
A8. The positive electrode active material of embodiment A7, wherein the coating layer comprises yttrium, and the yttrium content of the coating layer ranges from about 0.01 mol% to about 1 mol% based on 100 mol% of a total metal in the first positive electrode active material excluding lithium.
A9. The positive electrode active material of embodiment A7, wherein the coating layer comprises aluminium, and the aluminium content in the coating layer ranges from about 0.1 mol% to about 2 mol% based on 100 mol% of a total metal in the first positive electrode active material excluding lithium.
A10. The positive electrode active material of embodiment A7, wherein a thickness of the coating layer of the first positive electrode active material ranges from about 5 nm to about 500 nm.
A11. The positive electrode active material of embodiment A1, wherein in the layered lithium nickel-manganese-based composite oxide of the second positive electrode active material, the nickel content ranges from about 60 mol% to about 80 mol% and the manganese content is greater than or equal to about 15 mol% based on 100 mol% of a total metal content of the layered lithium nickel-manganese-based composite oxide excluding lithium.
A12. The positive electrode active material of embodiment A1, wherein the layered lithium nickel-manganese-based composite oxide of the second positive electrode active material further comprises aluminium, and an aluminium content in the layered lithium nickel-manganese-based composite oxide ranges from about 1 mol% to about 3 mol% based on 100 mol% of a total metal content of the layered lithium nickel-manganese-based composite oxide excluding lithium.
A13. The positive electrode active material of embodiment A1, wherein in the layered lithium nickel-manganese-based composite oxide of the second positive electrode active material, a cobalt content ranges from about 0 mol% to about 0.01 mol% based on 100 mol% of a total metal content of the layered lithium nickel-manganese-based composite oxide excluding lithium.
A14. The positive electrode active material of embodiment A1, wherein the layered lithium nickel-manganese-based composite oxide of the second positive electrode active material is represented by Chemical Formula 2:

   [Chemical Formula 2] Liₐ₂Niₓ₂Mn_{y2}Al_{z2}M²_{w2}O_{2-b2}X_{b2}

   wherein, in Chemical Formula 2, 0.9≤a2≤1.8, 0.6≤x2≤0.8, 0.1≤y2≤0.4, 0≤z2≤0.03, 0≤w2≤0.3, 0.9≤x2+y2+z2+w2≤1.1, and 0≤b2≤0.1, M² is one or more elements selected from B, Ba, Ca, Ce, Cr, Fe, Mg, Mo, Nb, Si, Sn, Sr, Ti, V, W, and Zr, and X is one or more elements selected from F, P, and S.
A15. The positive electrode active material of embodiment A1, wherein the second positive electrode active material comprises a coating layer comprising yttrium, aluminium, or a combination thereof.
A16. The positive electrode active material of embodiment A15, wherein the coating layer comprises yttrium, and a yttrium content of the coating layer ranges from about 0.01 mol% to about 1 mol% based on 100 mol% of a total metal content of the coating layer excluding lithium.
A17. The positive electrode active material of embodiment A15, wherein the coating layer comprises aluminium, and an aluminium content of the coating layer ranges from about 0.1 mol% to about 2 mol% based on 100 mol% of a total metal content of the second positive electrode active material excluding lithium.
A18. The positive electrode active material of embodiment A15, wherein the coating layer of the second positive electrode active material has a thickness of about 5 nm to about 500 nm.
A19. The positive electrode active material of embodiment A15, wherein the coating layer of the second positive electrode active material comprises yttrium and aluminium, and in the coating layer, yttrium exists in the form of islands and aluminium exists in the form of a continuous film.
A20. The positive electrode active material of embodiment A15, wherein the second positive electrode active material comprises a first coating layer comprising aluminium, and a second coating layer disposed on the first coating layer comprising yttrium.
A21. A positive electrode, comprising a positive electrode current collector, and a positive electrode active material layer on the positive electrode current collector, wherein the positive electrode active material layer includes the positive electrode active material of embodiment A1.
A22. The positive electrode of embodiment A21, wherein
   the positive electrode active material layer has a density of about 3.5 g/cc to about 3.7 g/cc.
A23. A rechargeable lithium battery, comprising the positive electrode of embodiment A21, a negative electrode, and an electrolyte.
A24. The rechargeable lithium battery of embodiment A23, wherein a charge voltage is greater than or equal to about 4.45 V.

Examples and comparative examples of the present disclosure are described below. However, the following examples are only examples of the present disclosure, and the present disclosure is not limited to the following examples.

### Preparation Example 1: Preparation of first positive electrode active material (LCO large particles)

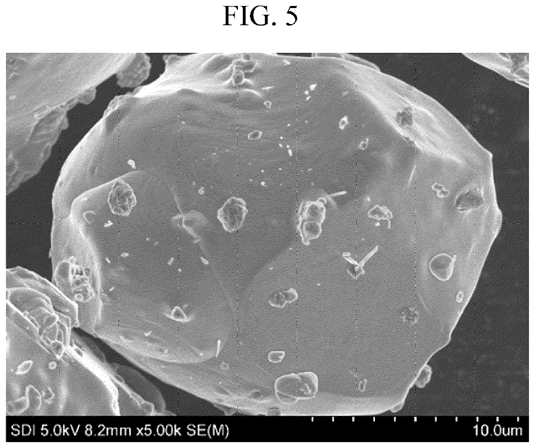

A first composite oxide having a composition of LiCo_{0.985}Al_{0.015}O₂ and an average particle diameter (D₅₀) of about 18 µm was prepared. An aluminium oxide was added to the first composite oxide and then, mixed for 20 minutes to 60 minutes. Herein, the aluminium oxide was designed to have an aluminium content of 0.4 mol% based on 100 mol% of a total metal content excluding lithium in the final first positive electrode active material. This mixture was then heat-treated at 950 °C for 8 hours to prepare the first positive electrode active material. FIG. 5 shows a scanning electron microscope image of the first positive electrode active material.

### Preparation Example 2: Preparation of first positive electrode active material (LCO large particles)

The first composite oxide was added together with water and yttrium nitrate to coat the yttrium on the first composite oxide. The product was then dried. The dried product was mixed with Al₂O₃ and then, heat-treated at 950 °C for 8 hours to prepare a first positive electrode active material. Herein, a content of yttrium in the yttrium nitrate was designed to be 0.05 mol% based on 100 mol% of a total metal content excluding lithium in the final first positive electrode active material.

### Preparation Example 3: Preparation of first positive electrode active material (LCO large particles)

A first composite oxide of LiCo_{0.985}Al_{0.015}O₂ was used as a first positive electrode active material without the Al and Y coating.

Table 1 briefly shows the designs of Preparation Examples 1 to 3. Table 1 also shows capacity and a cycle-life, which were measured in a method of Evaluation Example 1 after respectively applying the positive electrode active materials according to Preparation Examples 1 to 3 to manufacture a positive electrode and a rechargeable lithium battery cell in the same manner as in Example 1 described later.

**(Table 1)**

| | First positive electrode active material (LCO large particles) | | | | |
|---|---|---|---|---|---|
| | Al doping (mol%) | Al coating (mol%) | Y coating (mol%) | 4.5 V capacity (mAh/g) | 4.5 V cycle-life (%, @50 cy) |
| Preparation Example 1 | 1.5 | 0.4 | - | 195.9 | 90.2 |
| Preparation Example 2 | 1.5 | 0.4 | 0.05 | 194.5 | 89.3 |
| Preparation Example 3 | 1.5 | - | - | 196.7 | 87.5 |

### Preparation Example 4: Preparation of second positive electrode active material (NM small particles)

Ni_{0.75}Mn_{0.25}(OH)₂, LiOH, and Al₂O₃ were mixed in a mole ratio of 1:1:0.02 and then, heat-treated at 850 °C for 8 hours under an oxygen atmosphere to prepare a second composite oxide in the form of single particles having a composition of LiNi_{0.75}Mn_{0.23}Al_{0.02}O₂ and an average particle diameter (D₅₀) of about 3 µm.

After mixing aluminium sulfate and yttrium nitrate with a distilled water solvent, the second composite oxide was added thereto and then mixed for 20 minutes to 60 minutes. Herein, the aluminium sulfate was designed to have an aluminium content of 0.4 mol% based on 100 wt% of total metal content excluding lithium in a final second positive electrode active material, while the yttrium nitrate was designed to have a yttrium content of 0.05 mol%. After removing the solvent from the solution and drying at 190 °C, a heat treatment was performed at 825 °C under an oxygen atmosphere for 8 hours to prepare a second positive electrode active material.

### Preparation Example 5: Preparation of second positive electrode active material (NM small particles)

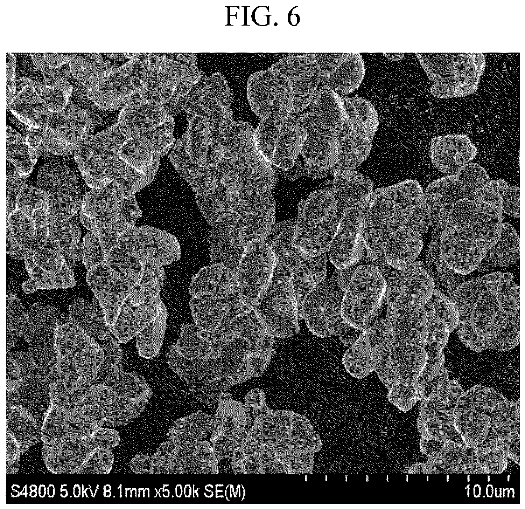

A second positive electrode active material was prepared in the same manner as in Preparation Example 4 except that the yttrium content of the yttrium nitrate was designed to be 0.1 mol%. FIG. 6 shows a scanning electron microscope image of the second positive electrode active material according to Preparation Example 5.

### Preparation Example 6: Preparation of second positive electrode active material (NM small particles)

A second positive electrode active material was prepared in the same manner as in Preparation Example 4 except that the Al coating alone was performed without adding the yttrium nitrate.

Table 2 briefly shows designs of Preparation Examples 4 to 6. Table 2 also shows capacity and a cycle life, which were measured in the same method as in Evaluation Example 1 after manufacturing a positive electrode and a rechargeable lithium battery cell in the same manner as in Example 1 by applying each of the positive electrode active materials of Preparation Examples 4 to 6.

**(Table 2)**

| | Second positive electrode active material (NM small particles) | | | | |
|---|---|---|---|---|---|
| | Al doping (mol%) | Al coating (mol%) | Y coating (mol%) | 4.5 V capacity (mAh/g) | 4.5 V cycle-life (%, @50 cy) |
| Preparation Example 4 | 2.0 | 0.4 | 0.05 | 202.5 | 87.5 |
| Preparation Example 5 | 2.0 | 0.4 | 0.1 | 199.9 | 85.3 |
| Preparation Example 6 | 2.0 | 0.4 | - | 203.1 | 82.4 |

### Preparation Example 7: LCO small particles

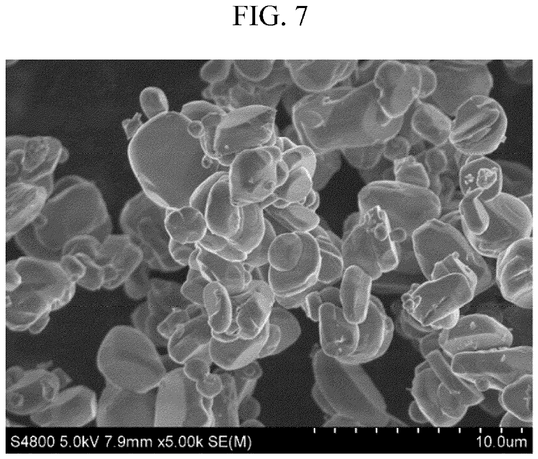

After mixing aluminium sulfate with a distilled water solvent, LiCo_{0.98}Al_{0.02}O₂ particles having an average particle diameter (D₅₀) of about 4 µm were added thereto and then, mixed for 20 minutes to 60 minutes. Herein, an aluminium content in the aluminium sulfate was designed to be 0.4 mol% based on 100 mol% of a total metal content excluding lithium in the final positive electrode active material. Removing the solvent from the mixed solution, drying at 190 °C, and heating at 825 °C for 8 hours afforded the positive electrode active material according to Preparation Example 7. FIG. 7 shows a scanning electron microscope image of the positive electrode active material (LCO small particles) according to Preparation Example 7.

### Preparation Example 8: LCO small particles

A positive electrode active material was prepared substantially in the same manner as in Preparation Example 7 except that Al and Y were coated by adding yttrium nitrate with the aluminium sulfate. Herein, a content of yttrium in the yttrium nitrate was designed to be 0.05 mol% based on 100 mol% of total metal content excluding lithium in the final positive electrode material.

In Table 3, the designs of Preparation Examples 7 and 8 are briefly shown. Table 3 also shows capacity and a cycle life, which were measured in the same method as in Evaluation Example 1 after manufacturing a positive electrode and a rechargeable lithium battery cell in the same manner as in Example 1 by applying each of the positive electrode active materials of Preparation Examples 7 to 8.

**(Table 3)**

| | LCO small particles | | | | |
|---|---|---|---|---|---|
| | Al doping (mol%) | Al coating (mol%) | Y coating (mol%) | 4.5 V capacity (mAh/g) | 4.5 V cycle-life (%, @50 cy) |
| Preparation Example 7 | 2.0 | 0.4 | - | 197.5 | 85.2 |
| Preparation Example 8 | 2.0 | 0.4 | 0.05 | 196.2 | 84.3 |

### Example 1

### 1. Manufacture of Positive Electrode

The first positive electrode active material of Preparation Example 1 (LCO large particles) and the second positive electrode active material of Preparation Example 4 (NM small particles) were mixed in a weight ratio of 8:2 to prepare a positive electrode active material according to Example 1.

98.5 wt% of the positive electrode active material, 1.0 wt% of a polyvinylidene fluoride binder, and 0.5 wt% of a carbon nanotube conductive material were mixed to prepare a positive electrode active material layer slurry, and the slurry was coated on an aluminium foil current collector and then dried and compressed to manufacture a positive electrode. A density of the final compressed positive electrode was about 3.52 g/cc.

### 2. Manufacturing of Rechargeable Lithium Battery Cell

97.5 wt% of a graphite negative electrode active material, 1.5 wt% of carboxymethyl cellulose, and 1 wt% of a styrene butadiene rubber in a water solvent were mixed to prepare a negative electrode active material layer slurry. The negative electrode active material layer slurry was coated on a copper foil current collector and then, dried and compressed to manufacture a negative electrode.

A polytetrafluoroethylene separator was used, and an electrolyte prepared by dissolving 1 M LiPF₆ in a mixed solvent of ethylene carbonate and dimethyl carbonate in a volume ratio of 3:7 was used to manufacture a rechargeable lithium battery cell in a common method.

### Comparative Example 1

A positive electrode active material, a positive electrode, and rechargeable lithium battery cell were manufactured substantially in the same method as in Example 1 except that the first positive electrode active material of Preparation Example 1 (LCO large particles) and the second positive electrode active material of Preparation Example 7 (LCO small particles) were mixed in a weight ratio of 8:2 to prepare the positive electrode active material.

### Evaluation Example 1: Evaluation of electrochemical properties and mixture density

The rechargeable lithium battery cells according to Example 1 and Comparative Example 1 were charged to 4.5 V at a constant current of 0.2 C and to 0.05C at a constant voltage, discharged to a cut-off voltage of 3.0 V at 0.2 C at 25 °C as initial charge and discharge to measure initial discharge capacity, and the results are shown in Table 4.

Subsequently, the cells were 50 times or more repeatedly charged at 1.0 C within a voltage range of 3.0 V to 4.5 V and discharged at 1.0 C at 45 °C to calculate a ratio of 50^{th} cycle discharge capacity to the initial discharge capacity, and the results are shown in Table 4.

In addition, each positive electrode density in a pressed state of Example 1 and Comparative Example 1 was measured, and the results are shown in Table 4.

**(Table 4)**

| | Large particles (80 wt%) | Small particles (20 wt%) | 4.5 V capacity (mAh/g) | 4.5 V cycle-life (%, @50 cy) | Positive electrode density (g/cc) |
|---|---|---|---|---|---|
| Example 1 | Preparation Example 1 (LCO large particles) | Preparation Example 4 (NM small particles) | 199.1 | 92.6 | 3.90 |
| Comparative Example 1 | Preparation Example 1 (LCO large particles) | Preparation Example 7 (LCO small particles) | 197.3 | 91.5 | 3.91 |

Referring to Table 4, Example 1, while maintaining almost the same positive electrode density as Comparative Example 1, exhibited improved initial discharge capacity and high-voltage cycle-life characteristics, compared with Comparative Example 1.

While this disclosure has been described in connection with what is presently considered to be practical example embodiments, it is to be understood that the disclosure is not limited to these embodiments. On the contrary, it is intended to cover various modifications and equivalent arrangements included within the scope of the appended claims.

Embodiments are set out in the following clauses:
Clause 1. A positive electrode active material, comprising
   a first positive electrode active material in a form of particles including lithium cobalt-based oxide, and
   a second positive electrode active material in a form of single particles including a layered lithium nickel-manganese-based composite oxide having a nickel content of greater than or equal to about 60 mol% based on 100 mol% of a total metal excluding lithium,
   wherein at least one of the first positive electrode active material and the second positive electrode active material includes a coating layer including yttrium.
Clause 2. The positive electrode active material of clause 1, wherein
   an average particle diameter (D₅₀) of the particles of the first positive electrode active material is larger than an average particle diameter (D₅₀) of the single particles of the second positive electrode active material.
Clause 3. The positive electrode active material of clause 1 or clause 2, wherein
   an average particle diameter (D₅₀) of the particles of the first positive electrode active material is about 10 µm to about 20 µm, and
   an average particle diameter (D₅₀) of the single particles of the second positive electrode active material is about 0.5 µm to about 8 µm.
Clause 4. The positive electrode active material of any one of clauses 1 to 3, wherein
   based on a total 100 wt% of the first positive electrode active material and the second positive electrode active material, the first positive electrode active material is included in an amount of about 60 wt% to about 95 wt%, and the second positive electrode active material is included in an amount of about 5 wt% to about 40 wt%.
Clause 5. The positive electrode active material of any one of clauses 1 to 4, wherein
   the lithium cobalt-based oxide of the first positive electrode active material is represented by Chemical Formula 1:

      [Chemical Formula 1] Liₐ₁COₓ₁M¹₁₋ₓ₁O2
   wherein, in Chemical Formula 1, 0.9≤a1≤1.8, 0.6≤x1≤1, and M¹ is one or more elements selected from Al, B, Ba, Ca, Ce, Cr, Cu, F, Fe, Mg, Mn, Mo, Nb, P, S, Si, Sr, Ti, V, W, and Zr.
Clause 6. The positive electrode active material of any one of clauses 1 to 5, wherein
   the lithium cobalt-based oxide of the first positive electrode active material further includes aluminium, and
   an aluminium content in the lithium cobalt-based oxide is about 1 mol% to about 3 mol% based on 100 mol% of metals excluding lithium in the lithium cobalt-based oxide.
Clause 7. The positive electrode active material of any one of clauses 1 to 6, wherein
   the first positive electrode active material includes particles including lithium cobalt-based oxide, and a coating layer disposed on the surface of the particles and that including yttrium, aluminium, or a combination thereof.
Clause 8. The positive electrode active material of clause 7, wherein
   the coating layer includes yttrium, and the yttrium content of the coating layer is about 0.01 mol% to about 1 mol% based on 100 mol% of a total metal excluding lithium in the first positive electrode active material.
Clause 9. The positive electrode active material of clause 7 or clause 8, wherein
   the coating layer includes aluminium, and the aluminium content in the coating layer is about 0.1 mol% to about 2 mol% based on 100 mol% of a total metal excluding lithium in the first positive electrode active material.
Clause 10. The positive electrode active material of any one of clauses 7 to 9, wherein
   a thickness of the coating layer of the first positive electrode active material is about 5 nm to about 500 nm.
Clause 11. The positive electrode active material of any one of clauses 1 to 10, wherein
   in the layered lithium nickel-manganese-based composite oxide of the second positive electrode active material, the nickel content is about 60 mol% to about 80 mol% and the manganese content is greater than or equal to about 15 mol% based on 100 mol% of a total metal excluding lithium.
Clause 12. The positive electrode active material of any one of clauses 1 to 11, wherein
   the layered lithium nickel-manganese-based composite oxide of the second positive electrode active material further includes aluminium, and an aluminium content in the layered lithium nickel-manganese-based composite oxide is about 1 mol% to about 3 mol% based on 100 mol% of a total metal excluding lithium.
Clause 13. The positive electrode active material of any one of clauses 1 to 12, wherein
   in the layered lithium nickel-manganese-based composite oxide of the second positive electrode active material, a cobalt content is about 0 mol% to about 0.01 mol% based on 100 mol% of a total metal excluding lithium.
Clause 14. The positive electrode active material of any one of clauses 1 to 13, wherein
   the layered lithium nickel-manganese-based composite oxide of the second positive electrode active material is represented by Chemical Formula 2:

      [Chemical Formula 2] Liₐ₂Niₓ₂Mn_{y2}Al_{z2}M²_{w2}O_{2-b2}X_{b2}
   wherein, in Chemical Formula 2, 0.9≤a2≤1.8, 0.6≤x2≤0.8, 0.1≤y2≤0.4, 0≤z2≤0.03, 0≤w1≤0.3, 0.9≤x2+y2+z2+w2≤1.1, and 0≤b2≤0.1, M² is one or more elements selected from B, Ba, Ca, Ce, Cr, Fe, Mg, Mo, Nb, Si, Sn, Sr, Ti, V, W, and Zr, and X is one or more elements selected from F, P, and S.
Clause 15. The positive electrode active material of any one of clauses 1 to 14, wherein
   the second positive electrode active material is disposed on the surface of the single particle and includes a coating layer including yttrium, aluminium, or a combination thereof.
Clause 16. The positive electrode active material of clause 15, wherein
   the coating layer includes yttrium, and an yttrium content of the coating layer is about 0.01 mol% to about 1 mol% based on 100 mol% of a total metal excluding lithium.
Clause 17. The positive electrode active material of clause 15 or clause 16, wherein
   the coating layer includes aluminium, and an aluminium content of the coating layer is about 0.1 mol% to about 2 mol% based on 100 mol% of a total metal excluding lithium in the second positive electrode active material.
Clause 18. The positive electrode active material of any one of clauses 15 to 17, wherein
   the coating layer of the second positive electrode active material has a thickness of about 5 nm to about 500 nm.
Clause 19. The positive electrode active material of any one of clauses 15 to 18, wherein
   the coating layer of the second positive electrode active material includes both yttrium and aluminium, and in the coating layer, yttrium exists in the form of islands and aluminium exists in the form of a continuous film.
Clause 20. The positive electrode active material of any one of clauses 15 to 19, wherein
   the second positive electrode active material includes a first coating layer disposed on the surface of the single particle and including aluminium, and a second coating layer disposed on the first coating layer and including yttrium.
Clause 21. A positive electrode, comprising
   a positive electrode current collector, and
   a positive electrode active material layer on the positive electrode current collector,
   wherein the positive electrode active material layer includes the positive electrode active material of any one of clauses 1 to 20.
Clause 22. The positive electrode of clause 21, wherein
   the positive electrode active material layer has a density of about 3.5 g/cc to about 3.7 g/cc.
Clause 23. A rechargeable lithium battery, comprising
   the positive electrode of clause 21 or clause 22,
   a negative electrode, and
   an electrolyte.
Clause 24. The rechargeable lithium battery of clause 23, wherein
   a charge voltage is greater than or equal to about 4.45 V.

### <Description of Symbols>

| | | | |
|---|---|---|---|
| 100: | rechargeable lithium battery | 10: | positive electrode |
| 11: | positive electrode lead tab | 12: | positive terminal |
| 20: | negative electrode | 21: | negative electrode lead tab |
| 22: | negative terminal | 30: | separator |
| 40: | electrode assembly | 50: | case |
| 60: | sealing member | 70: | electrode tab |
| 71: | positive electrode tab | 72: | negative electrode tab |

## Claims

1. A positive electrode active material, comprising
particles of a first positive electrode active material comprising a lithium cobalt-based oxide, and
particles of a second positive electrode active material in a form of single particles comprising a layered lithium nickel-manganese-based composite oxide having a nickel content of greater than or equal to about 60 mol% based on 100 mol% of a total metal content of the second positive electrode active material excluding lithium,
wherein at least one of the first positive electrode active material and the second positive electrode active material is coated with a layer comprising yttrium.

2. The positive electrode active material as claimed in claim 1, wherein:
(i) an average particle diameter (D₅₀) of the particles of the first positive electrode active material is greater than an average particle diameter (D₅₀) of the single particles of the second positive electrode active material; and/or
(ii) an average particle diameter (D₅₀) of the particles of the first positive electrode active material ranges from about 10 µm to about 20 µm, and
an average particle diameter (D₅₀) of the single particles of the second positive electrode active material ranges from about 0.5 µm to about 8 µm.

3. The positive electrode active material as claimed in claim 1 or claim 2, wherein
the first positive electrode active material is about 60 weight% to about 95 weight% of the positive electrode active material, and the second positive electrode active material is about 5 weight% to about 40 weight% of the positive electrode active material.

4. The positive electrode active material as claimed in any one of claims 1 to 3, wherein
the lithium cobalt-based oxide of the first positive electrode active material is represented by Chemical Formula 1:
[Chemical Formula 1] Liₐ₁COₓ₁M¹₁₋ₓ₁O2
wherein, in Chemical Formula 1, 0.9≤a1≤1.8, 0.6≤x1≤1, and M¹ is one or more elements selected from Al, B, Ba, Ca, Ce, Cr, Cu, F, Fe, Mg, Mn, Mo, Nb, P, S, Si, Sr, Ti, V, W, and Zr.

5. The positive electrode active material as claimed in any one of claims 1 to 4, wherein
the lithium cobalt-based oxide of the first positive electrode active material further includes aluminium, and
an aluminium content in the lithium cobalt-based oxide is about 1 mol% to about 3 mol% based on 100 mol% of metals in the lithium cobalt-based oxide excluding lithium.

6. The positive electrode active material as claimed in any one of claims 1 to 5, wherein
the particles of the first positive electrode active material comprise lithium cobalt-based oxide and a coating layer disposed on the surface of the particles, the coating layer comprising yttrium, aluminium, or a combination of yttrium and aluminium, optionally wherein
the coating layer comprises yttrium, and the yttrium content of the coating layer ranges from about 0.01 mol% to about 1 mol% based on 100 mol% of a total metal in the first positive electrode active material excluding lithium.

7. The positive electrode active material as claimed in claim 6, wherein:
(i) the coating layer comprises aluminium, and the aluminium content in the coating layer ranges from about 0.1 mol% to about 2 mol% based on 100 mol% of a total metal in the first positive electrode active material excluding lithium; and/or
(ii) a thickness of the coating layer of the first positive electrode active material ranges from about 5 nm to about 500 nm.

8. The positive electrode active material as claimed in any one of claims 1 to 7, wherein,
in the layered lithium nickel-manganese-based composite oxide of the second positive electrode active material, the nickel content ranges from about 60 mol% to about 80 mol% and the manganese content is greater than or equal to about 15 mol% based on 100 mol% of a total metal content of the layered lithium nickel-manganese-based composite oxide excluding lithium.

9. The positive electrode active material as claimed in any one of claims 1 to 8, wherein:
(i) the layered lithium nickel-manganese-based composite oxide of the second positive electrode active material further comprises aluminium, and an aluminium content in the layered lithium nickel-manganese-based composite oxide ranges from about 1 mol% to about 3 mol% based on 100 mol% of a total metal content of the layered lithium nickel-manganese-based composite oxide excluding lithium; and/or
(ii) in the layered lithium nickel-manganese-based composite oxide of the second positive electrode active material, a cobalt content ranges from about 0 mol% to about 0.01 mol% based on 100 mol% of a total metal content of the layered lithium nickel-manganese-based composite oxide excluding lithium; and/or
(iii) the layered lithium nickel-manganese-based composite oxide of the second positive electrode active material is represented by Chemical Formula 2:
[Chemical Formula 2] Liₐ₂Niₓ₂Mn_{y2}Al_{z2}M²_{w2}O_{2-b2}X_{b2}
wherein, in Chemical Formula 2, 0.9≤a2≤1.8, 0.6≤x2≤0.8, 0.1≤y2≤0.4, 0≤z2≤0.03, 0≤w2≤0.3, 0.9≤x2+y2+z2+w2≤1.1, and 0≤b2≤0.1, M² is one or more elements selected from B, Ba, Ca, Ce, Cr, Fe, Mg, Mo, Nb, Si, Sn, Sr, Ti, V, W, and Zr, and X is one or more elements selected from F, P, and S.

10. The positive electrode active material as claimed in any one of claims 1 to 9, wherein
the second positive electrode active material comprises a coating layer on the single particles comprising yttrium, aluminium, or a combination thereof.

11. The positive electrode active material as claimed in claim 10, wherein:
(i) the coating layer comprises yttrium, and a yttrium content of the coating layer ranges from about 0.01 mol% to about 1 mol% based on 100 mol% of a total metal content of the second positive electrode active material excluding lithium; and/or
(ii) the coating layer comprises aluminium, and an aluminium content of the coating layer ranges from about 0.1 mol% to about 2 mol% based on 100 mol% of a total metal content of the second positive electrode active material excluding lithium.

12. The positive electrode active material as claimed in claim 10 or claim 11, wherein
the coating layer of the second positive electrode active material has a thickness of about 5 nm to about 500 nm.

13. The positive electrode active material as claimed in any one of claims 10 to 12, wherein:
(i) the coating layer of the second positive electrode active material comprises yttrium and aluminium, and in the coating layer, yttrium exists in the form of islands and aluminium exists in the form of a continuous film; and/or
(ii) the second positive electrode active material comprises a first coating layer on the surface of the single particle and comprises aluminium, and a second coating layer disposed on the first coating layer comprising yttrium.

14. A positive electrode, comprising
a positive electrode current collector, and
a positive electrode active material layer on the positive electrode current collector,
wherein the positive electrode active material layer includes the positive electrode active material as claimed in any one of claims 1 to 13, optionally wherein
the positive electrode active material layer has a density of about 3.5 g/cc to about 3.7 g/cc.

15. A rechargeable lithium battery, comprising
the positive electrode as claimed in claim 14,
a negative electrode, and
an electrolyte, optionally wherein
a charge voltage of the rechargeable lithium battery is greater than or equal to about 4.45 V.
